# EUROPEAN PATENT APPLICATION

(11) **EP 4 394 842 A1**
(43) Date of publication of application: **03.07.2024**
(21) Application number: 23202100.6
(22) Date of filing: 06.10.2023
(51) Int. Cl.: H01J 37/32

(54) **INDUCTIVE COUPLING ANTENNA UNIT AND PLASMA TREATMENT APPARATUS**

(30) Priority: 27.12.2022 JP 2022210266; 02.06.2023 JP 2023091619
(71) Applicant: Plasma Ion Assist Co., Ltd., Kyoto-shi, Kyoto 612-8373 (JP)
(72) Inventor: SUZUKI, Yasuo, Otsu-shi, Shiga, 520-0225 (JP); WATANABE, Masanori, Katano-shi, Osaka, 576-0021 (JP)
(74) Representative: Müller Hoffmann & Partner

(57) **Abstract**

An inductive coupling antenna unit is airtightly mounted in an opening provided in a wall of a vacuum chamber. The inductive coupling antenna unit includes: a lid, airtightly covering the opening; an antenna conductor, provided on the lid; and a heating heater, provided on an inner surface of the lid.

## Description

### CROSS-REFERENCE TO RELATED APPLICATIONS

This application claims the priority benefits of Japan Application No. 2022-210266, filed on December 27, 2022 and Japan Application No. 2023-091619, filed on June 2, 2023. The entirety of each of the above-mentioned patent applications is hereby incorporated by reference herein and made a part of this specification.

### BACKGROUND

### Technical Field

The disclosure relates to an inductive coupling antenna unit and a plasma treatment apparatus including the inductive coupling antenna unit.

### Related Art

As a conventional plasma treatment apparatus, there is one in which high frequency power is supplied to an antenna to generate plasma within a vacuum chamber while a substrate is conveyed within the vacuum chamber, as illustrated in Japanese Patent Laid-open No. 2019-117773.

In the configuration described above, in order to ensure the performance or the like of a coating film formed on the substrate, it is necessary to heat a treated surface of the substrate to a desired temperature range and maintain the treated surface within the temperature range. Since heating by plasma alone is insufficient, conventionally, a heating heater is provided on the back side of the treated surface of the substrate so that heating can be performed.

However, it is the treated surface of the substrate that is to be heated. In the configuration in which heating is performed from the back side of the treated surface as described above, since the treated surface is unable to be directly heated, it takes longer than necessary to heat a surface of the substrate to the desired temperature range and to maintain that temperature.

### SUMMARY

An inductive coupling antenna unit according to the disclosure is an inductive coupling antenna unit airtightly mounted in an opening provided in a wall of a vacuum chamber. The inductive coupling antenna unit includes: a lid, airtightly covering the opening; an antenna conductor, provided on the lid; and a heating heater, provided on the antenna conductor side with respect to a treatment target conveyed within the vacuum chamber.

### BRIEF DESCRIPTION OF THE DRAWINGS

FIG. 1 schematically illustrates an overall configuration of a plasma treatment apparatus according to one embodiment of the disclosure.
FIG. 2-1 schematically illustrates an inductive coupling antenna unit of the same embodiment.
FIG. 2-2 schematically illustrates an inductive coupling antenna unit of another embodiment.
FIG. 3 schematically illustrates a configuration of an antenna conductor of the same embodiment.
FIG. 4 schematically illustrates a configuration of a plasma treatment apparatus of the same embodiment.
FIG. 5 schematically illustrates a configuration of an antenna conductor of another embodiment.
FIG. 6 schematically illustrates an inductive coupling antenna unit of another embodiment.
FIG. 7 schematically illustrates an inductive coupling antenna unit of another embodiment.
FIG. 8 schematically illustrates a configuration of a plasma treatment apparatus of another embodiment.
FIG. 9 schematically illustrates an inductive coupling antenna unit of another embodiment.

### DESCRIPTION OF THE EMBODIMENTS

The disclosure provides an inductive coupling antenna unit with excellent responsiveness for quickly heating a surface of a substrate to a desired temperature range and maintaining the surface temperature of the substrate within the temperature range.

That is, the inductive coupling antenna unit according to the disclosure is an inductive coupling antenna unit airtightly mounted in an opening provided in a wall of a vacuum chamber. The inductive coupling antenna unit includes: a lid, airtightly covering the opening; an antenna conductor, provided on the lid; and a heating heater, provided on the antenna conductor side with respect to a treatment target conveyed within the vacuum chamber.

According to the plasma treatment apparatus configured in this way, since the heating heater is provided on the antenna conductor side with respect to the treatment target, a treated surface of a substrate can be directly heated, and can be quickly heated with good responsiveness to a desired temperature range.

Preferably, the heating heater is provided in a heater accommodation space separated from a plasma generation area by a plasma shield plate.

With such a configuration, while the heating heater is arranged near the treatment target, contamination of the heating heater can be prevented.

In another embodiment, the heating heater is provided on an inner surface of the lid.

Even with such an arrangement, since the heating heater is provided on the same side as the antenna conductor, the treated surface of the substrate can be directly heated, and can be quickly heated with good responsiveness to the desired temperature range.

In a more specific embodiment, the lid includes a metal flange provided along the opening and an insulator plate supported by the metal flange. The heating heater is accommodated in a recess formed in the insulator plate.

Preferably, the inductive coupling antenna unit according to the disclosure includes a quartz plate that closes the recess.

With such a configuration, since contamination of the heating heater can be prevented by the lid, and the lid can be easily cleaned with, for example, oxygen plasma, maintenance is easy.

Preferably, in a cross section orthogonal to a longitudinal direction of the antenna conductor, the heating heater is provided on both sides of the antenna conductor.

With such a configuration, the treated surface of the substrate can be efficiently and uniformly heated, and temperature control of the surface of the substrate is facilitated.

Preferably, the heating heater is an infrared lamp.

If an infrared lamp is used in this way, since excellent control of output of heat rays and excellent responsiveness are achieved, response is faster and controllability is better than a case where a nichrome wire is used as a heating heater.

Preferably, the inductive coupling antenna unit according to the disclosure further includes a reflector provided in the recess and reflecting heat from the heating heater into the vacuum chamber.

This allows relatively efficient heating of the surface of the substrate.

In a plasma treatment apparatus according to the disclosure, the inductive coupling antenna unit described above is mounted in one or a plurality of openings provided in the wall of the vacuum chamber.

With such a configuration, the plasma treatment apparatus can exhibit the same effects as the inductive coupling antenna unit described above.

Preferably, the inductive coupling antenna unit is provided on each of a front side and a back side of a substrate conveyed within the vacuum chamber, and is configured to be able to heat the substrate from both the front side and the back side at the same time.

With such a configuration, the substrate can be relatively efficiently heated.

Preferably, a plurality of the inductive coupling antenna units are provided along a conveyance direction of the substrate, and the heating heater of each of the inductive coupling antenna units is independently controllable.

With such a configuration, a set temperature of each heating heater can be controlled considering that heat is accumulated in the substrate during conveyance, and a desired plasma treatment can be performed.

Preferably, the heating heater is accommodated in a heater accommodation space separated from a plasma generation area in the vacuum chamber via a plasma shield plate.

In this case, since the heating heater is provided in the heater accommodation space separated from the plasma generation area via the plasma shield plate, while the heating heater is arranged near the treatment target, contamination of the heating heater can be prevented.

Preferably, the inductive coupling antenna unit further includes a casing that surrounds the plasma generation area in the vacuum chamber and that is formed with an opening facing the treatment target. The treatment target is heated by blackbody radiation from an inner surface of the casing.

In this case, the treatment target can be heated by blackbody radiation from the inner surface of the casing, and a wide range of the treatment target can be uniformly heated.

In a more specific embodiment, a diamond-like carbon (DLC) film is formed on the inner surface of the casing.

One embodiment of an inductive coupling antenna unit and a plasma treatment apparatus equipped with the inductive coupling antenna unit according to the disclosure will be described below with reference to the drawings.

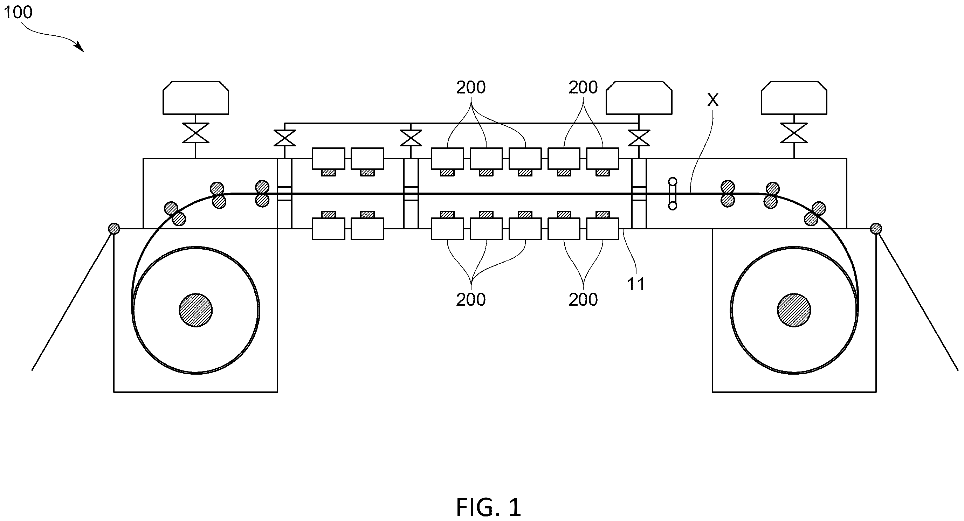

As illustrated in FIG. 1, a plasma treatment apparatus 100 of the present embodiment is of a so-called roll-to-roll system. In the plasma treatment apparatus 100, while a substrate X of a sheet-like shape made of aluminum or the like, which serves as a treatment target, is conveyed within a vacuum chamber 11, by generating high density plasma between the sheet-like substrate X and an inductive coupling antenna unit 200, a surface of the substrate X is plasma-treated.

The vacuum chamber 11 is maintained at a predetermined degree of vacuum by a vacuum exhaust unit and a gas introducing unit. For example, a mixed gas of argon and hydrogen is introduced therein, and the vacuum chamber 11 is adjusted to a predetermined pressure of, for example, 1 Pa.

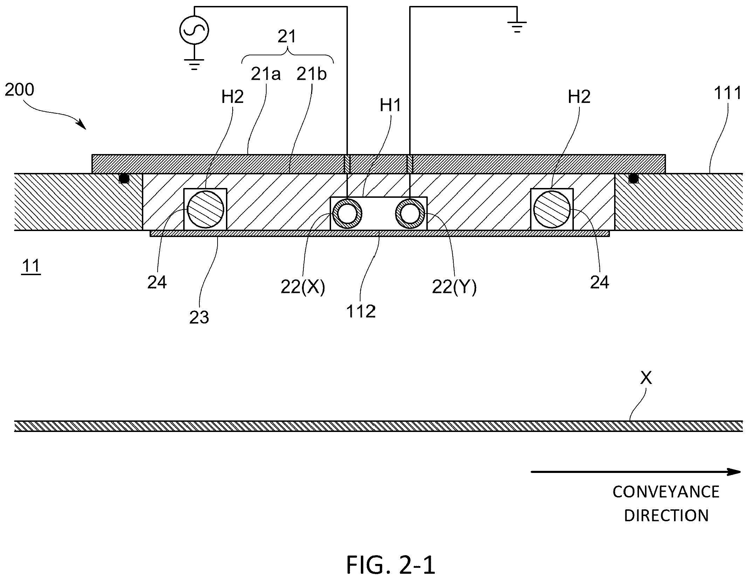

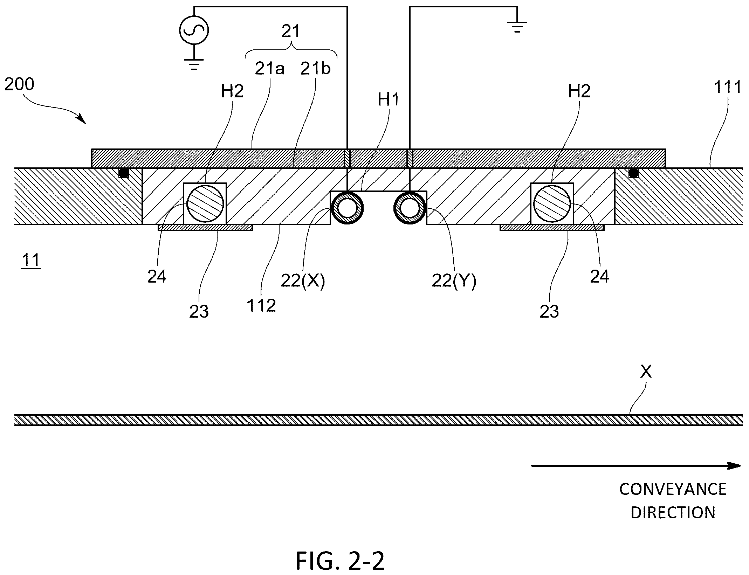

As illustrated in FIG. 2-1 and FIG. 2-2, an opening 112 of a rectangular shape when viewed from above is formed in an upper wall 111 of the vacuum chamber 11. By fitting the inductive coupling antenna unit 200 described later into the opening 112, the inside of the vacuum chamber 11 may be sealed.

Since the plasma treatment apparatus 100 of the present embodiment is characterized by the inductive coupling antenna unit 200, details thereof will be described below.

The inductive coupling antenna unit 200 is based on a so-called inductively coupled plasma (ICP) method in which discharge plasma is excited using an electromagnetic field generated by causing a high frequency current to flow to an inductive coupling antenna (hereinafter also simply referred to ICP antenna).

As illustrated in FIG. 2-1 and FIG. 2-2, the inductive coupling antenna unit 200 is arranged to face a treated surface of the substrate X conveyed within the vacuum chamber 11. Specifically, the inductive coupling antenna unit 200 includes: a lid 21, closing the opening 112 provided in a wall of the vacuum chamber 11; an antenna conductor 22, arranged along an inner surface (on the vacuum chamber 11 side) of the lid 21; and a quartz plate 23, covering or shielding the antenna conductor 22.

As illustrated in FIG. 2-1 and FIG. 2-2, the lid 21 includes: a metal flange 21a, provided along the opening 112 of the vacuum chamber 11; and an insulator plate 21b, supported by the metal flange 21a. Here, the metal flange 21a and the insulator plate 21b are integrally provided.

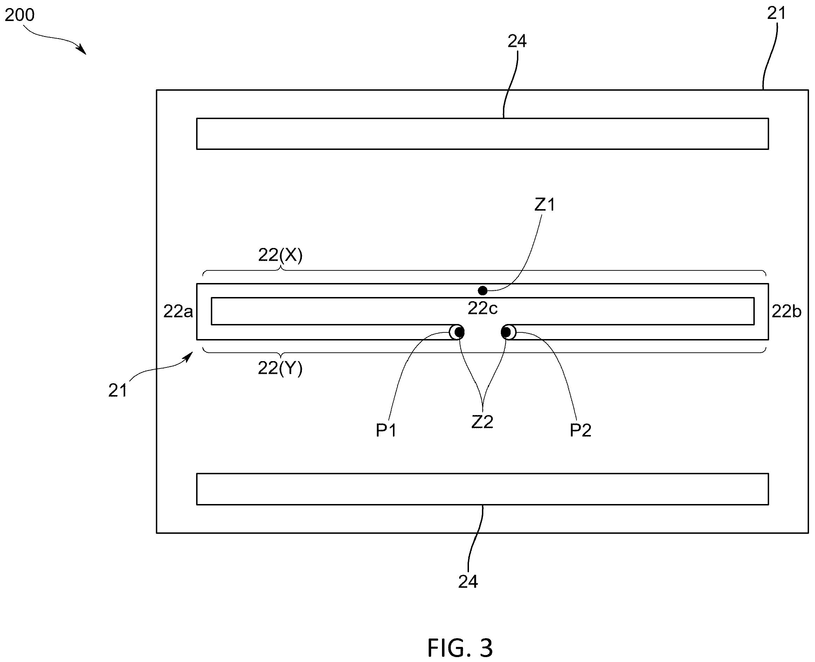

As illustrated in FIG. 3, the antenna conductor 22 is a rectangular frame formed by bending a single metal pipe. In this frame (antenna conductor 22), a central portion of one (hereinafter also referred to as feeding side antenna conductor 22X) of the long sides is connected to a feeding terminal Z1, and a central portion of the other (hereinafter also referred to as a ground side antenna conductor 22Y) is fixed to the lid 21 via a vacuum seal member or the like and grounded.

In the present embodiment, U-shaped antenna conductors are arranged left-right symmetrically. A high frequency current fed to the central portion of the feeding side antenna conductor 22X flows left and right, makes a U-turn at both end portions, and flows toward the central portion of the ground side antenna conductor 22Y.

In the antenna conductor 22 configured in this way, the high frequency current fed through the feeding terminal Z1 to a longitudinal central portion 22c of the feeding side antenna conductor 22X flows toward both end portions 22a and 22b on the left and right of the antenna conductor 22 of a U-shape, makes a U-turn and flows in an opposite direction through the ground side antenna conductor 22Y, and flows into a ground terminal Z2 of the central portion of the ground side antenna conductor 22Y. Accordingly, the direction of the high frequency current flowing through the feeding side antenna conductor 22X is opposite to the direction of the high frequency current flowing through the ground side antenna conductor 22Y.

That is, the antenna conductor 22 constitutes a reciprocating circuit for the high frequency current supplied to the longitudinal central portion 22c of the feeding side antenna conductor 22X. In such a reciprocating circuit, mutual inductance is generated between reciprocating antenna conductors, and impedance of the antenna conductor against the high frequency current is canceled and decreased by an amount corresponding to the mutual inductance.

In the inductive coupling antenna unit 200 according to the disclosure, the feeding side antenna conductor 22X and the ground side antenna conductor 22Y are arranged substantially parallel along the inner surface of the lid 21. The high frequency currents flowing in the antenna conductors 22X and 22Y are in opposite directions to each other, and a maximum electromagnetic field is generated between the antenna conductors 22X and 22Y. The inductive coupling antenna unit 200 has a configuration utilizing this strong electromagnetic field in a most effective manner, and is very effective in generating high density plasma. Even in a low gas pressure area, discharge is likely to occur and stable discharge is maintained.

A material of the antenna conductor 22 is not specified. However, in order to feed high frequency power of, for example, 13.56 MHz, a metal material with good conductivity, for example, a copper material or an aluminum material, is preferable.

Since the antenna conductor 22 is heated to several hundred °C when having a high frequency current flowing therethrough, the antenna conductor 22 is preferably a metal pipe that can be cooled, for example, water-cooled. According to the present embodiment, since the central portion of the antenna conductor 22 is configured to be grounded, cooling by water or the like is easy.

If a metal pipe such as a copper pipe or an aluminum pipe is used as the antenna conductor 22, the antenna conductor 22 can be cooled by flowing a coolant such as water therein. Specifically, by injecting the coolant from an inlet P1 on one side of the central portion of the ground side antenna conductor 22Y, causing the coolant to travel around the antenna conductor 22 and discharging the coolant from an outlet P2 on the other side of the central portion of the ground side antenna conductor 22Y, the entire antenna conductor 22 can be cooled.

The insulator plate 21b constituting the lid 21 is preferably made of a workable material with excellent insulation and heat resistance, and may be made of, for example, a ceramics material such as an alumina material or silicon nitride. If the antenna conductor 22 can be sufficiently cooled, a polyether ether ketone (PEEK) material or a Teflon-based organic material with excellent heat resistance can be used.

In the present embodiment, since the antenna conductor 22 is mounted inside the vacuum chamber 11, the antenna conductor 22 is exposed to the discharge plasma. Accordingly, depending on treatment conditions, there is a risk that a surface of the antenna conductor 22 may be sputtered by ion irradiation, and the metal forming the antenna conductor 22 may scatter as impurities. Accordingly, in order to suppress contamination by sputtering, the surface of the antenna conductor 22 is preferably covered with a dielectric material such as a quartz tube.

Specifically, as illustrated in FIG. 2-1, an antenna recess H1 is provided in the inner surface of the lid 21, and the antenna conductor 22 is accommodated in the antenna recess H1. The antenna recess H1 is formed by recessing the insulator plate 21b constituting the lid 21 in a thickness direction. By closing the antenna recess H1 by the quartz plate 23, plasma is prevented from entering the surface of the antenna conductor 22.

If the antenna conductor 22 is covered with a quartz tube, the antenna conductor 22 covered with the quartz tube may be accommodated in the antenna recess H1, as illustrated in FIG. 2-2. In this case, high density plasma is excited between the antenna conductors 22X and 22Y where a strongest high frequency electromagnetic field is provided, and this high density plasma can be effectively utilized. In this configuration, there is no need to close the antenna recess H1 by the quartz plate 23.

The shape or size of the antenna recess H1 is not limited to that illustrated in FIG. 2-1 or FIG. 2-2. For example, the shape of the antenna recess H1 may be a rectangular shape in cross section or a partially circular shape. For example, the antenna recess H1 may reach an upper surface (that is, a surface facing the outside of the vacuum chamber 11) of the insulator plate 21b.

As illustrated in FIG. 2-1, FIG. 2-2 and FIG. 3, the inductive coupling antenna unit 200 of the present embodiment further includes a heating heater 24 on the antenna conductor 22 side with respect to the substrate X, the substrate X serving as the treatment target conveyed within the vacuum chamber 11.

Specifically, in the present embodiment, the heating heater 24 is accommodated in a heater recess H2 separate from the antenna recess H1 formed on the inner surface of the lid 21.

Like the antenna recess H1, the heater recess H2 that accommodates the heating heater 24 is formed by recessing the insulator plate 21b constituting the lid 21 in the thickness direction. The heater recess H2 is closed by the quartz plate 23, thereby shielding a surface of the heating heater 24.

As illustrated in FIG. 3, the heating heater 24 has an elongated shape extending along the longitudinal direction of the antenna conductor 22. Specifically, the heating heater 24 is, for example, an infrared lamp.

More specifically, as illustrated in FIG. 2-1 and FIG. 2-2, in a cross section orthogonal to the longitudinal direction of the antenna conductor 22, the heating heater 24 is provided in each position sandwiching the antenna conductor 22.

These heating heaters 24 are arranged to face the treated surface of the substrate X together with the antenna conductor 22, in other words, arranged on the same side as the antenna conductor 22 with respect to the substrate X, and directly heat the treated surface of the substrate X.

Each heating heater 24 is controlled by a control device (not illustrated). The heating heaters 24 may be configured to be able to control a set temperature independently of each other, or may be controlled by each other to reach the same set temperature.

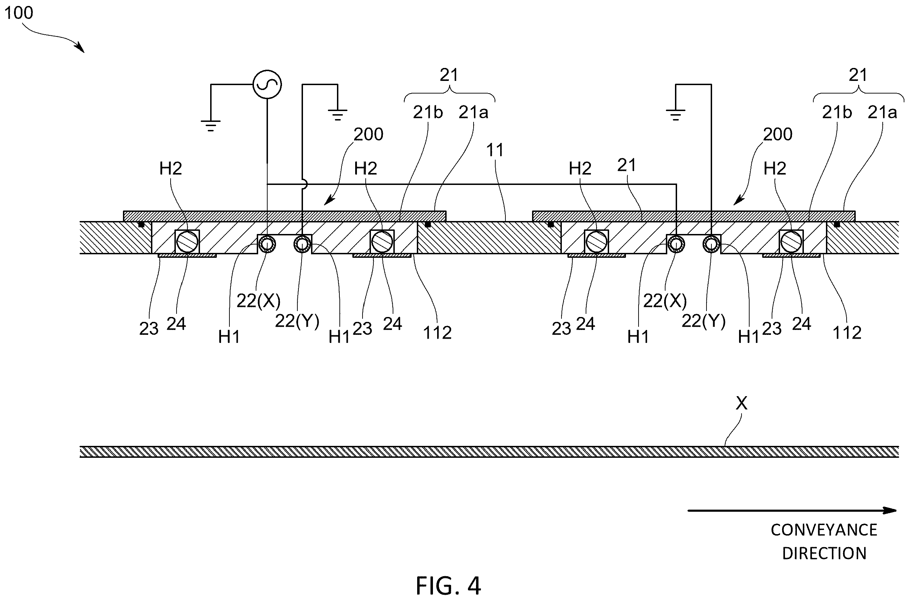

Here, as illustrated in FIG. 4, in the plasma treatment apparatus 100, the inductive coupling antenna unit 200 may be mounted in each of a plurality of openings 112 provided in the wall of the vacuum chamber 11.

Specifically, a plurality of inductive coupling antenna units 200 are provided along a conveyance direction of the substrate X. Accordingly, uniform high density discharge plasma can be excited over a large area.

The configuration illustrated in FIG. 4 indicates the case where the antenna conductor 22 is covered with the quartz tube. Although the antenna recess H1 is not closed by the quartz plate 23, since the antenna conductor 22 is covered with the quartz tube, there is no need to close the antenna recess H1 with the quartz plate 23. It is desirable to utilize the high density plasma excited within the antenna recess H1.

Back to FIG. 1, in the present embodiment: the inductive coupling antenna unit 200 is provided on each of the front side and the back side of the substrate X conveyed within the vacuum chamber 11, and is configured to be able to heat the substrate X from the front and back sides at the same time.

Each heating heater 24 of the inductive coupling antenna unit 200 is independently controllable. For example, considering that heat is accumulated in the substrate X during conveyance, the set temperature of each heating heater 24 can be set as appropriate. For example, the set temperature of the heating heater 24 located downstream in the conveyance direction of the substrate X may be set lower than the set temperature of the heating heater 24 located upstream in the conveyance direction of the substrate X.

According to the plasma treatment apparatus 100 of the present embodiment configured in this way, since the heating heater 24 is provided on the same side as the antenna conductor 22, the treated surface of the substrate X can be directly heated, and can be quickly heated with good responsiveness to a desired temperature range.

Since the heater recess H2 is closed by the quartz plate 23, the heating heater 24 can be prevented from being contaminated. Since the lid 21 can be easily cleaned with, for example, oxygen plasma, maintenance is easy.

Furthermore, since the heating heater 24 is provided in each position sandwiching the antenna conductor 22 in the cross section orthogonal to the longitudinal direction of the antenna conductor 22, the treated surface of the substrate X can be efficiently heated, and temperature control is facilitated.

In addition, since the heating heater 24 is an infrared lamp, response is faster and controllability is better than the case where a nichrome wire is used.

The disclosure is not limited to the above embodiment.

For example, the number of heating heaters 24 provided in one inductive coupling antenna unit 200 is not limited to two as described in the above embodiment, and may be one, or three or more.

The arrangement of the heating heater 24 is not limited to that described in the above embodiment. For example, the heating heater 24 may be provided in a position sandwiched by the antenna conductors 22.

Furthermore, the heating heater 24 is not limited to an infrared lamp, and may use a nichrome wire.

Moreover, in the above embodiment, the heating heater 24 is accommodated in the heater recess H2 formed in the lid 21. However, instead of forming the heater recess H2 in the lid 21, the heating heater 24 may be provided on the inner surface of the lid 21.

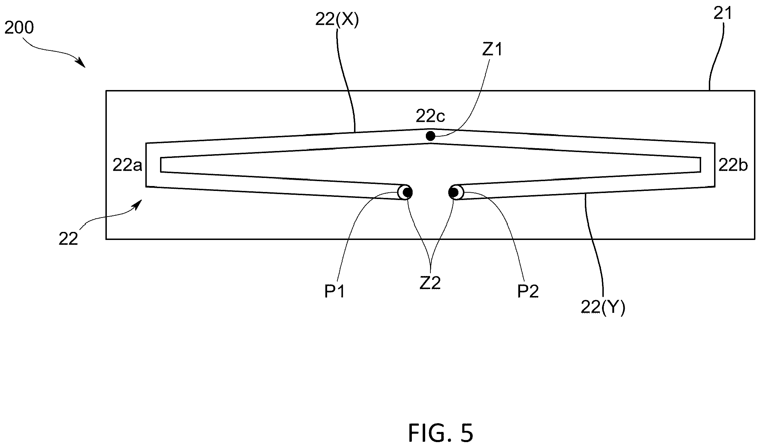

As illustrated in FIG. 5, in the inductive coupling antenna unit 200, an interval between the central portions of the feeding side antenna conductor 22X and the ground side antenna conductor 22Y may be larger than an interval at both end portions.

With this configuration, a reduction in plasma density at both end portions can be compensated, and uniform density plasma can be excited over the entire surface of the antenna conductor 22.

The inductive coupling antenna unit 200 is not limited to a single metal pipe formed into a frame shape. The inductive coupling antenna unit 200 may be formed by connecting a plurality of metal pipes into a frame shape.

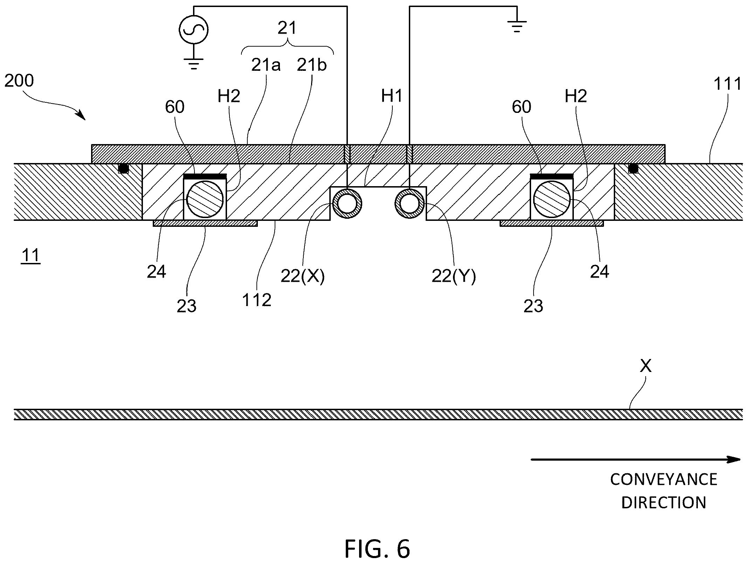

In addition, as illustrated in FIG. 6, the inductive coupling antenna unit 200 according to the disclosure may further include a reflector 60 provided in the heater recess H2 and reflecting a heat ray radiated from the heating heater 24 into the vacuum chamber 11.

In this case, the reflector 60 is preferably provided on a bottom surface of the heater recess H2, in other words, on a surface facing the inside of the vacuum chamber 11. The heater recess H2 may be formed in a partially circular shape such as a semicircular shape, and an inner surface thereof may be set as the reflector 60.

The configuration illustrated in FIG. 6 indicates the case where the antenna conductor 22 is covered with the quartz tube. The antenna recess H1 is not closed by the quartz plate 23. However, if the antenna conductor 22 is not covered with a quartz tube, it is desirable to close the antenna recess H1 by the quartz plate 23.

Furthermore, in the above embodiment, high frequency power of a frequency of 13.56 MHz is used as the high frequency power. However, the disclosure is not limited thereto, and high frequency power of a frequency of 30 kHz to 30 MHz can be applied.

The inductive coupling antenna unit 200 is not limited to being mounted on the upper wall 111 of the vacuum chamber 11. Depending on the form of the plasma treatment apparatus 100, the inductive coupling antenna unit 200 may be mounted on, for example, a sidewall or a lower wall of the vacuum chamber 11. In the case where the inductive coupling antenna unit 200 is mounted on the sidewall of the vacuum chamber 11, the substrate X can be plasma-treated while being conveyed in an up-down direction (vertical direction).

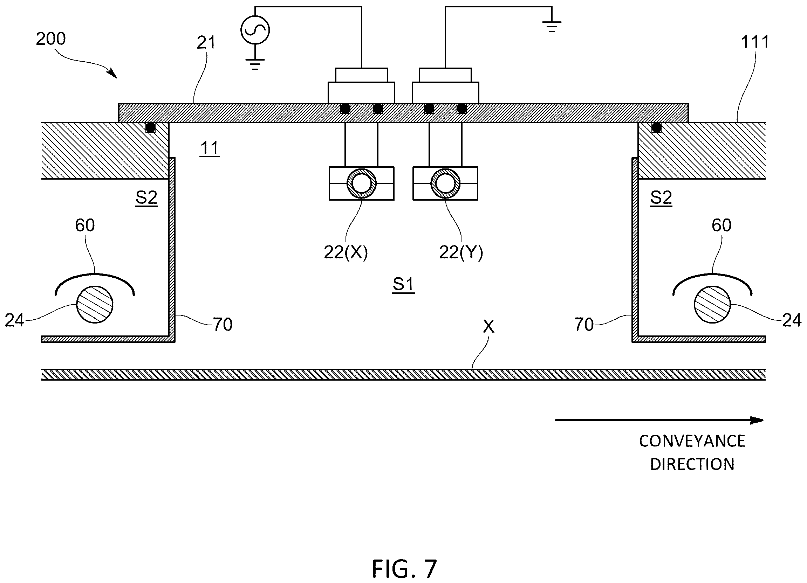

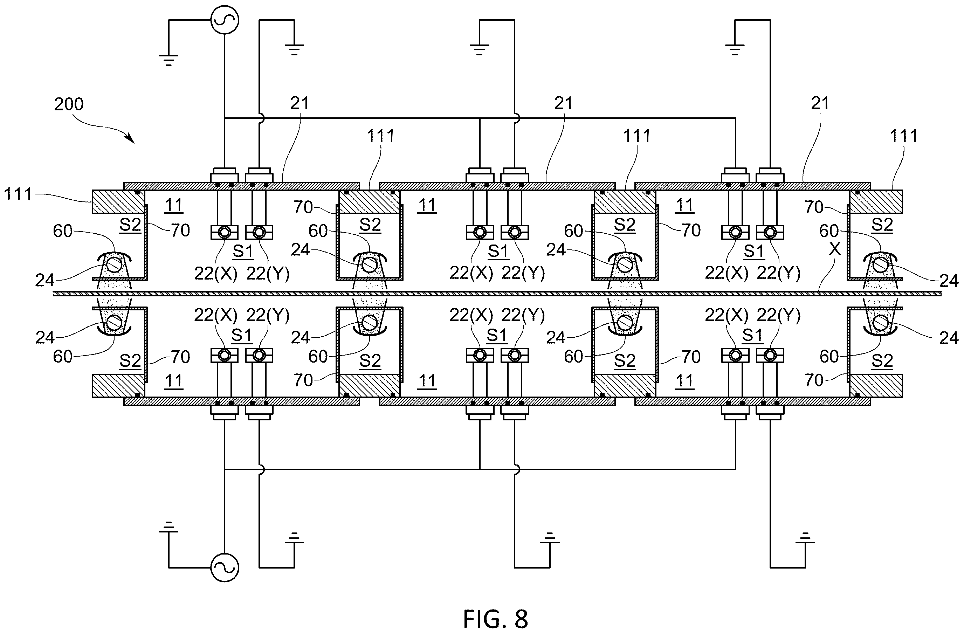

Furthermore, as illustrated in FIG. 7 and FIG. 8, in the inductive coupling antenna unit 200 according to the disclosure, a heater accommodation space S2 is formed which is separated from a plasma generation area S1 by a plasma shield plate 70, and the heating heater 24 may be accommodated in the heater accommodation space S2. The heating heater 24 here is an infrared lamp. However, the heating heater 24 may also use a nichrome wire.

The plasma shield plate 70 is composed of a member that blocks plasma. The heater accommodation space S2 is a space formed so that plasma cannot enter therein.

More specifically, in this embodiment, the plasma shield plate 70 is attached to, for example, the upper wall 111 of the vacuum chamber 11. The heater accommodation space S2 is an elongated space extending from the upper wall 111 toward the substrate X in order to bring the heating heater 24 as close as possible to the substrate X.

In other words, the heater accommodation space S2 here is formed so that a dimension along a direction from the upper wall 111 toward the substrate X is longer than a dimension along the conveyance direction of the substrate X.

The heater accommodation space S2 is formed on both sides of the plasma generation area S1 along the conveying direction of the substrate X. In other words, the heating heater 24 is provided on both sides of the plasma generation area S1 along the conveying direction of the substrate X.

In these heater accommodation spaces S2, the reflector 60 that reflects the heat ray radiated from the heating heater 24 toward the substrate X is provided.

According to the inductive coupling antenna unit 200 configured in this way, since the heating heater 24 is provided on the same side as the antenna conductor 22, the treated surface of the substrate X can be directly heated, and can be quickly heated with good responsiveness to the desired temperature range.

Since the heating heater 24 is provided in the heater accommodation space S2 separated from the plasma generation area S 1 via the plasma shield plate 70, while the heating heater 24 is arranged near the substrate X, contamination of the heating heater 24 can be prevented.

As illustrated in FIG. 8, the inductive coupling antenna unit 200 like this may be arranged on each of the front side and the back side of the substrate X, as in the above embodiment.

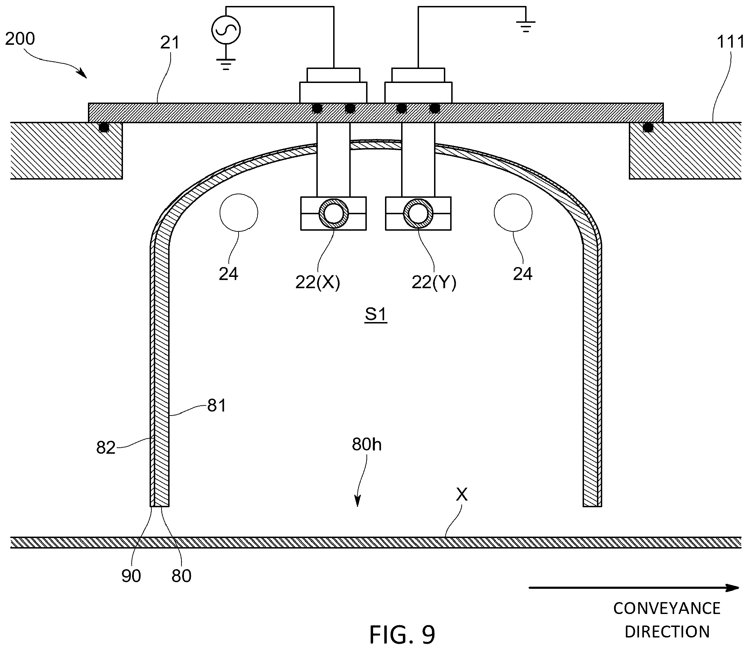

The plasma treatment apparatus 100 according to the disclosure may include the inductive coupling antenna unit 200 illustrated in FIG. 9.

Specifically, as illustrated in FIG. 9, the inductive coupling antenna unit 200 includes: a casing 80, surrounding the plasma generation area S 1 and accommodating the antenna conductor 22.

In the casing 80, an opening 80h facing the substrate X is formed. The casing 80 is formed of, for example, aluminum or stainless steel, and has, for example, a dome shape curved toward the lid 21 side. The shape of the casing 80 is not limited thereto, and may be, for example, a box shape (substantially rectangular parallelepiped shape) formed by a plurality of flat plates.

An internal space of the casing 80 is supplied with a source gas of the plasma. By supplying, as the source gas, a mixed gas of, for example, methane, acetylene and nitrogen and applying high frequency power from a high frequency power supply to the antenna conductor 22 via a matching box, discharge plasma containing carbon ions is generated in the internal space of the casing 80.

Accordingly, an inner surface 81 of the casing 80 is covered with a diamond-like carbon (DLC) film and heated to a high temperature by the heating heater 24. As a result, the inner surface 81 of the casing 81 acts as if it were a heat source. Blackbody radiation is generated from the inner surface 81, and the substrate X can be uniformly heated.

There may be concern that the heating heater 24 may be covered with the DLC film. However, since the heating heater 24 reaches a high temperature of, for example, about 500 °C to 600 °C, the DLC adhering to the heating heater 24 may sublimate, and the above concern does not become a problem.

The casing 80 here is arranged floating from the vacuum chamber 11 in order to prevent from being unnecessarily cooled. Specifically, the casing 80 is kept out of contact with the lid 21 that is water-cooled. The casing 80 is attached to, for example, the upper wall 111 of the vacuum chamber 11.

In the case where a DLC film is formed on the substrate X, a negative bias voltage of -2 kV or more and -800 V or less, for example, may be applied to the substrate X.

In such a configuration, since there is concern about discharge between the casing 80 and, for example, the upper wall 111 of the vacuum chamber 11 or the lid 21, in order to prevent this discharge, here, an insulator 90 formed by, for example, alumite treatment, is provided on an outer surface 82 of the casing 80.

According to the inductive coupling antenna unit 200 configured in this way, the substrate X can be heated by blackbody radiation from the inner surface 81 of the casing 80, and a wide range of the substrate X can be uniformly heated.

The inductive coupling antenna unit 200 like this may be arranged on each of the front side and the back side of the substrate X, as in the above embodiment.

In the inductive coupling antenna unit 200 described above, the heating heater 24 does not necessarily have to be accommodated in the casing 80 and may be arranged outside the casing 80. In this case, impurities arranged in the plasma generation area S1 can be reduced.

Furthermore, the inner surface 81 of the casing 80 does not necessarily have to be formed with a DLC film. For example, a black paint may be applied on the inner surface 81 in advance, or a black casing may be used.

It goes without saying that the disclosure is not limited to the above embodiments but may be modified in various ways without departing from the gist thereof.

## Claims

1. An inductive coupling antenna unit, airtightly mounted in an opening provided in a wall of a vacuum chamber, the inductive coupling antenna unit comprising:
a lid, airtightly covering the opening;
an antenna conductor, provided on the lid; and
a heating heater, provided on the antenna conductor side with respect to a treatment target conveyed within the vacuum chamber.

2. The inductive coupling antenna unit according to claim 1, wherein
the heating heater is provided in a heater accommodation space separated from a plasma generation area by a plasma shield plate.

3. The inductive coupling antenna unit according to claim 1, wherein
the heating heater is provided on an inner surface of the lid.

4. The inductive coupling antenna unit according to claim 3, wherein
the lid comprises a metal flange provided along the opening and an insulator plate supported by the metal flange; and
the heating heater is accommodated in a recess formed in the insulator plate.

5. The inductive coupling antenna unit according to claim 4, further comprising:
a quartz plate, closing the recess.

6. The inductive coupling antenna unit according to claim 1, wherein
in a cross section orthogonal to a longitudinal direction of the antenna conductor, the heating heater is provided on both sides of the antenna conductor.

7. The inductive coupling antenna unit according to claim 1, wherein
the heating heater is an infrared lamp.

8. The inductive coupling antenna unit according to claim 1, further comprising:
a reflector, reflecting heat from the heating heater into the vacuum chamber.

9. A plasma treatment apparatus, wherein
the inductive coupling antenna unit according to claim 1 is mounted in one or a plurality of openings provided in the wall of the vacuum chamber.

10. The plasma treatment apparatus according to claim 9, wherein
the inductive coupling antenna unit is provided on each of a front side and a back side of a substrate conveyed within the vacuum chamber, and is configured to be able to heat the substrate from both the front side and the back side at the same time.

11. The plasma treatment apparatus according to claim 9, wherein
a plurality of the inductive coupling antenna units are provided along a conveyance direction of a substrate; and
the heating heater of each of the inductive coupling antenna units is independently controllable.

12. The plasma treatment apparatus according to claim 9, wherein
the heating heater is accommodated in a heater accommodation space separated from a plasma generation area in the vacuum chamber via a plasma shield plate.

13. The plasma treatment apparatus according to claim 9, wherein
the inductive coupling antenna unit further comprises a casing that surrounds a plasma generation area in the vacuum chamber and that is formed with an opening facing the treatment target; and
the treatment target is heated by blackbody radiation from an inner surface of the casing.

14. The plasma treatment apparatus according to claim 13, wherein
a DLC film is formed on the inner surface of the casing.
